# EUROPEAN PATENT APPLICATION

(11) **EP 4 769 936 A1**
(43) Date of publication of application: **01.07.2026**
(21) Application number: 25747863.6
(22) Date of filing: 24.01.2025
(51) Int. Cl.: H02P 27/06, G06F 119/08, G01K 7/00

(54) **POWER SUPPLY DEVICE, ELECTRICAL SYSTEM, AND TEMPERATURE MEASUREMENT METHOD FOR POWER SUPPLY DEVICE**

(30) Priority: 31.01.2024 US 202463627094 P
(71) Applicant: Delta Electronics, Inc., Taoyuan City 333 (TW)
(72) Inventor: LIU, Hung-Hsiao, Taoyuan City, Taiwan 333 (CN); CHENG, Chang-Yi, Taoyuan City, Taiwan 333 (CN); SU, Wei-Te, Taoyuan City, Taiwan 333 (CN); WU, Chia-Chi, Taoyuan City, Taiwan 333 (CN)
(74) Representative: Nederlandsch Octrooibureau
(86) International application number: PCT/CN2025/074839
(87) International publication number: WO 2025/162295

(57) **Abstract**

A power supply device (100), including choke coils (CID1, CID2), voltage and current measurers (120a, 120b), a temperature sensor (130) and an operational circuit (140), wherein the voltage and current measurers (120a, 120b) are used for measuring a current (I1) flowing through the choke coils (CID1, CID2) and a voltage (V1) on a changeover switch; the temperature sensor (130) is used for measuring an initial temperature (T[0]) in an initial state; the operational circuit (140) is coupled to the voltage and current measurers (120a, 120b) and the temperature sensor (130); and the operational circuit (140) is used for: executing a power model (142), so as to calculate a first transient power (TP[1]) of the choke coils (CID1, CID2) on the basis of the initial temperature (T[0]), the voltage (V1) and the current (I1); and executing a thermal model (144), so as to calculate a first transient ideal temperature (TTI[1]) of the choke coils (CID1, CID2) on the basis of the first transient power (TP[1]). The present disclosure further relates to a temperature measurement method for the power supply device (100), and an electrical system (ES1, ES2).

## Description

### BACKGROUND

### Field of Invention

This disclosure relates to a power supply device and a temperature measurement method, and in particular to the cockpit monitoring device and method for estimating the transient temperature.

### Description of Related Art

Thermal management systems usually rely on basic thermal models and require manual calibration. Under varying operating conditions, this approach can lead to inefficiencies and possible failures. A temperature measuring sensor can be configured to measure operating ambient temperature of a circuit device. However, the temperature measuring sensor is mainly able to measure a steady-state temperature of the circuit device, such as temperature changes every 10 seconds during the continuous operation of the circuit device. The steady-state temperature measurement can only represent an overall operating ambient temperature of the circuit device, and cannot detect a transient temperature of a core circuit in the circuit device at a specific moment (for example, measuring a transient temperature of a choke at the moment of operating).

Since the well-known temperature sensor cannot measure or calculate the transient temperature of a specific component inside a circuit in real time, this may make temperature monitoring difficult.

### SUMMARY

The present disclosure provides a power supply device. The power supply device comprises a choke, a voltage current measuring device, a temperature sensor and a computing circuit. The voltage current measuring device is configured to measure a current flowing through the choke and a voltage on an inverter. The temperature sensor is configured to measure an initial temperature in an initial phase. The computing circuit is coupled to the voltage current measuring device and the temperature sensor, and the computing circuit is configured to: execute a power model to calculate to obtain a first transient power of the choke based on the initial temperature, the voltage and the current; and execute a thermal model to calculate to obtain a first transient ideal temperature of the choke based on the first transient power of the choke.

The present disclosure provides a temperature measurement method for a power supply device. The power supply device comprises a choke, a voltage current measuring device, a temperature sensor and a computing circuit. The temperature measurement method comprises: by the voltage current measuring device, measuring a current flowing through the choke and a voltage on a inverter; by the temperature sensor, measuring an initial temperature in an initial phase; by the computing circuit, executing a power model to calculate a first transient power of the choke based on the initial temperature, and the voltage and the current; and by the computing circuit, executing a thermal model to calculate a first transient ideal temperature of the choke based on the first transient power.

The present disclosure provides an electrical system. The electrical system comprises a working unit and a surrounding circuit. The working unit comprises a core position. The working unit is configured to generate an output energy according to an input energy. The surrounding circuit corresponds to the working unit. A temperature change and a time relationship between the core position of the electrical system and the surrounding circuit correspond to a thermal impedance function. The electrical system estimates a thermal system parameter of the core position by a temperature data of the surrounding circuit and the thermal impedance function.

In summary, the power supply device of the present disclosure can just measure the voltage on the switch of the inverter and the current flowing through the choke, and then instantly calculate to obtain the transient temperature on the choke in real time.

### BRIEF DESCRIPTION OF THE DRAWINGS

Fig. 1 is a schematic diagram of an electrical system according to an embodiment of the present disclosure.
Fig. 2 is a temperature curve diagram of the core position and the surrounding circuit according to the embodiment of Fig. 1.
Fig. 3 is a schematic diagram of an electrical system according to an embodiment of the present disclosure.
Fig. 4 is a schematic diagram of a power supply device according to an embodiment of the present disclosure.
Fig. 5 is a schematic diagram of a computing circuit according to the embodiment of Fig. 4.
Fig. 6 is another curve diagram of thermal model according to the embodiment of Fig. 5.
Fig. 7 is a curve diagram showing the relationship between the operating voltage-operating temperature of the operating unit and the service life of the operating unit according to an embodiment of the present disclosure.
Fig. 8 is a flow chart of a temperature measurement method according to an embodiment of the present disclosure.

### The symbols in the figures:

ES1, ES2: electrical system
WU1, WU2 : working unit
OC1, OC2 : surrounding circuit
CRP1, CRP2: core position
P_in, P_in1, P_in2 : input energy
P_out, P_out1, P_out2 : output energy
100: power supply device
110: inverter
SW1, SW2, SW3, SW4, SW5, SW6: switch
120a: voltage measuring device
120b: current measuring device
130: temperature sensor
140: computing circuit
SC1, SC2: cable
GND : ground terminal
C1, C2, C3, C4, C5, C6: capacitor
CID1, CID2: choke
MOT1: motor
V1: voltage
I1: current
F1: AC frequency
T[0]: initial temperature
T[1]-T[n]: operating ambient temperature
142: power model
142a : estimating unit
142b: integrating unit
144: thermal model
Emot: motor power loss
Ettl: total power
TP[1]-TP[n]: transient power
TTI[1]-TTI[n]: transient ideal temperature
t1, t2, t3, t4: time point
TEM1, TEM2, TEM3: temperature
500: temperature measurement method
S510, S520, S530, S540: step

### DETAILED DESCRIPTION

The embodiments are described in detail below with reference to the appended drawings to better understand the aspects of the present disclosure. In the figures, the same reference numerals represent the same or similar components or method flows.

### An electrical system

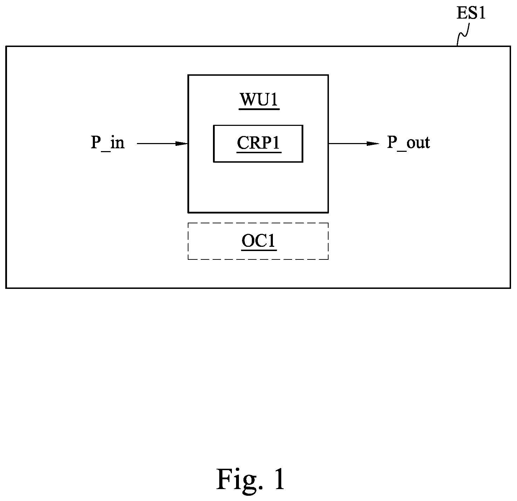

Referring to Fig. 1, Fig. 1 is a schematic diagram of an electrical system ES1 according to an embodiment of the present disclosure. In the embodiment of Fig. 1, the electrical system ES1 comprises a working unit WU1 and a surrounding circuit OC1 (in some embodiments, the surrounding circuit OC1 refers to a peripheral circuit located near the working unit WU1), the working unit WU1 comprises a core position CRP1, and the surrounding circuit OC1 corresponds to the working unit WU1. The electrical system ES1 can receive an input energy P_in and generate an output energy P_out according to the input energy P_in.

### Embodiment of establishing a thermal system parameter

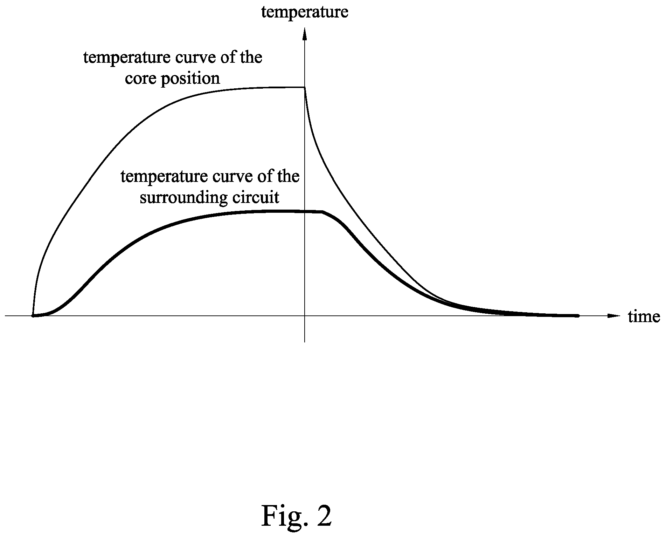

Referring to Fig. 2, Fig. 2 is a temperature curve diagram of the core position CRP1 and the surrounding circuit OC1 according to the embodiment of Fig. 1. In this embodiment, the input energy P_in of the electrical system ES1 comprises a heat energy input, and the core position CRP1 of the working unit WU1 is heated to increase the temperature until the heat energy input generated by the input energy P_in and the heat energy output generated by the output energy P_out of the core position CRP1 reach a balance, so that the core position CRP1 and the surrounding circuit OC1 reach a steady-state temperature. And then, the input energy P_in is reduced or stopped, and the core position CRP1 and the surrounding circuit OC1 begin to cool down, thereby obtaining the temperature change and the time relationship of the core position CRP1 and the surrounding circuit OC1 in Fig. 2. Through the temperature change and the time relationship of the core position CRP1 and the surrounding circuit OC1 through the thermal impedance curve conversion, the thermal impedance function can be further obtained to establish the thermal system parameter.

In the embodiment mentioned above, transient voltage changes at the measurement point of the object to be tested can be captured by using the JEDEC 51-14 test method or in conjunction with thermocouple wires. This technology converts voltage data into temperature rise data, thereby obtaining the time-thermal resistance relationship and the thermal resistance-heat capacity relationship of the object to be tested. These relationships are configured for dynamic monitoring to obtain the electrical system ES1 thermal impedance function or establish the thermal system parameter.

### Embodiment of an electrical system parameter

In one embodiment, the input energy P_in of the electrical system ES1 comprises the electrical energy input, and the operating condition of the working unit WU1 is controlled with respect to the key electrical characteristic of the working unit WU1. Under the control of the operating condition of the working unit WU1, the working unit WU1 can output the output energy P_out. By establishing the relationship between the key electrical characteristic and the operating condition of the working unit WU1, the electrical system parameter can be established.

In this embodiment, the electrical system ES1 can be any device configured to transfer or convert mechanical energy and electrical energy. The electrical system ES1 may exhibit thermal characteristics during the energy transfer or conversion process. Therefore, the electrical system ES1 can establish the thermal system parameter by the temperature change and the time relationship at the core position CRP1 and the peripheral position OC1 and by converting the thermal impedance curve to obtain the thermal impedance function. When the electrical system ES1 is operating, the transient thermal resistance and temperature of the core position CRP1 of the electrical system ES1 can be estimated by sensing the temperature of the surrounding circuit OC1 and the thermal impedance function of the electrical system ES1. Therefore, this embodiment can provide multiple reference values, and these reference values can be transient thermal resistance detection of the core position CRP1, core position CRP1 temperature detection, component overheat protection, and/or control parameters of the working unit WU1 when the electrical system ES1 is operating.

In other words, the electrical system ES1 may perform overheat protection on the working unit WU1 according to the thermal system parameter of the core position CRP1 and/or use the thermal system parameter as a control parameter.

In this embodiment, the dynamic temperature of the core position CRP1 of the working unit WU1 can be measured, for example, by monitoring the change in junction voltage of the semiconductor device under forward bias operation. Therefore, the electrical system ES1 can estimate the transient thermal resistance of the core position CRP1 and the dynamic temperature measurement of the core position CRP1 by temperature sensing of the surrounding circuit OC1 and the thermal impedance function of the electrical system ES1, and further evaluate the degradation of a physical state of the core position CRP1 of the working unit WU1 by evaluating the transient thermal resistance displacement.

In the embodiment mentioned above, the degradation of the physical state of the core position CRP1 of the working unit WU1 can be evaluated by comparing the thermal system parameter with the temperature data of the surrounding circuit OC1 through the thermal impedance function and referring to the electrical system parameter.

### Embodiment of the transient thermal resistance displacement

In the embodiment mentioned above, when the system configuration of the electrical system ES1 is changed, for which the thermal system parameters and the electrical system parameters have been obtained, a Computer Aided Engineering (CAE) simulation can be performed based on the difference in the system configuration change of the electrical system ES1 to obtain the thermal system parameters and the electrical system parameters of the electrical system ES1 after the configuration change.

In the embodiment mentioned above, by comparing the thermal impedance function with the temperature data of the surrounding circuit OC1, and referring to the operating condition of the working unit WU1, and comparing the thermal system parameters obtained by the computer-aided engineering with the electrical system parameters, the transient thermal resistance displacement can be evaluated, and the degradation of the working unit WU1 can be estimated.

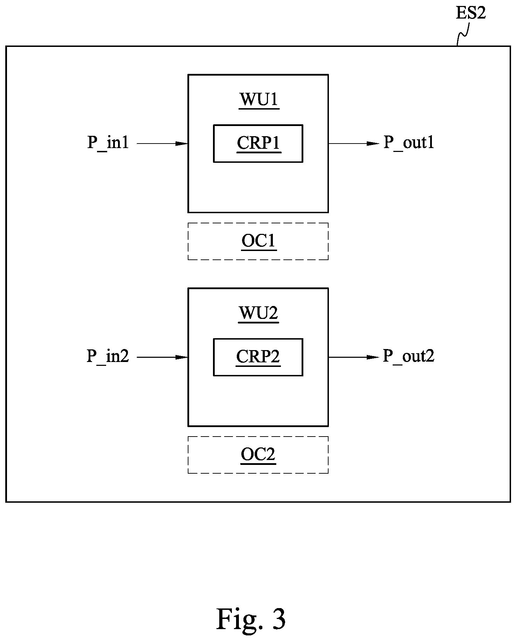

Referring to Fig. 3, Fig. 3 is a schematic diagram of an electrical system ES2 according to an embodiment of the present disclosure. The electrical system ES2 has a working unit WU1, and the working unit WU1 of the electrical system ES2 has the thermal system parameter and the electrical system parameter of the electrical system ES1 in Fig. 1. When the working unit WU1 of the electrical system ES2 is replaced by the working unit WU2, a computer-aided engineering (CAE) simulation can be performed based on the difference between the working unit WU1 and the working unit WU2 to obtain the thermal system parameter and the electrical system parameter of the electrical system ES2 replaced by the working unit WU2.

In this embodiment, input energy P_in1 and P_in2 of the electrical system ES2 both comprise an electrical energy input, and respectively control operating conditions of key electrical characteristics of the working units WU1 and WU2.

Under the control of the operating condition of the working unit WU1, the working unit WU1 can output the output energy P_out1, and the working unit WU2 can output the output energy P_out2. By establishing the relationship between the key electrical characteristics and the operating conditions of the working units WU1 and WU2, the electrical system ES2 can establish electrical system parameters.

In the present embodiment, the electrical system ES2 may be various energy transfer or energy conversion devices for mechanical energy and electrical energy. The electrical system ES2 may have thermal characteristics during the energy transfer or energy conversion process; therefore, the temperature change and the time relationship of the core position CRP1, CRP2 and the surrounding circuit OC1, OC2 (in some embodiments, the surrounding circuit OC2 refers to the peripheral circuit located near the working unit WU2, and the circuit of the surrounding circuit OC2 is different from the circuit of the surrounding circuit OC1) can be obtained through the thermal impedance curve conversion to obtain the thermal impedance function, and establish the thermal system parameter. When the electrical system ES2 is operated, the transient thermal resistance and the temperature of the core position CRP1, CRP2 of the electrical system ES2 can be estimated through the temperature sensing of the surrounding circuit OC1, OC2 and the thermal impedance function of the electrical system ES2. Therefore, the present embodiment can provide a plurality of reference values, and these reference values can be transient thermal resistance detection of the core position CRP1, transient thermal resistance detection of core position CRP2, core position CRP1 temperature detection, core position CRP2 temperature detection, component overheat protection, control parameters of working unit WU1, and control parameters of working unit WU2 when electrical system ES2 is operating.

In this embodiment, the dynamic temperature of the core position CRP1 of the working unit WU1 can be measured. Therefore, the electrical system ES2 can estimate the transient thermal resistance of the core position CRP1 through the temperature sensing of the surrounding circuit OC1 and the thermal impedance function of the electrical system ES2 and a dynamic temperature measurement of the core position CRP1 corresponding to temperature, and evaluate the transient thermal resistance displacement to further evaluate the degrading degree of one of the physical states of the core position CRP1 of the working unit WU1.

In addition, the dynamic temperature of the core position CRP2 of the working unit WU2 can be measured. Therefore, the electrical system ES2 can estimate the transient thermal resistance of the core position CRP2 through the temperature sensing of the surrounding circuit OC2 and the thermal impedance function of the electrical system ES2, and the temperature control core position CRP2 dynamic temperature measurement, and evaluate the transient thermal resistance displacement to further evaluate the degradation of one of the physical states of the core position CRP2 of the working unit WU2.

In one embodiment, the electrical system ES2 may further comprise a plurality of working units. According to this embodiment, the electrical system ES2 may comprise thermal system parameters and electrical system parameters of the plurality of working units.

In this embodiment, the plurality of working units of the electrical system ES2 may include the working units WU1 and WU2. The working unit WU1 and the working unit WU2 may obtain the thermal system parameters and the electrical system parameters respectively according to the above embodiments. The electrical system ES2 comprising the working unit WU1 and the working unit WU2 may be subjected to computer-aided engineering simulation according to the differences between the working units to obtain the thermal system parameters and the electrical system parameters of the electrical system ES2 comprising both the working units WU1 and WU2.

In the embodiment mentioned above, the working unit WU1 may further be a battery, a capacitor, a magnetic element, or the working unit WU1 may be a transformer, an inductor or a choke formed by magnetic elements.

### Embodiment related to the choke

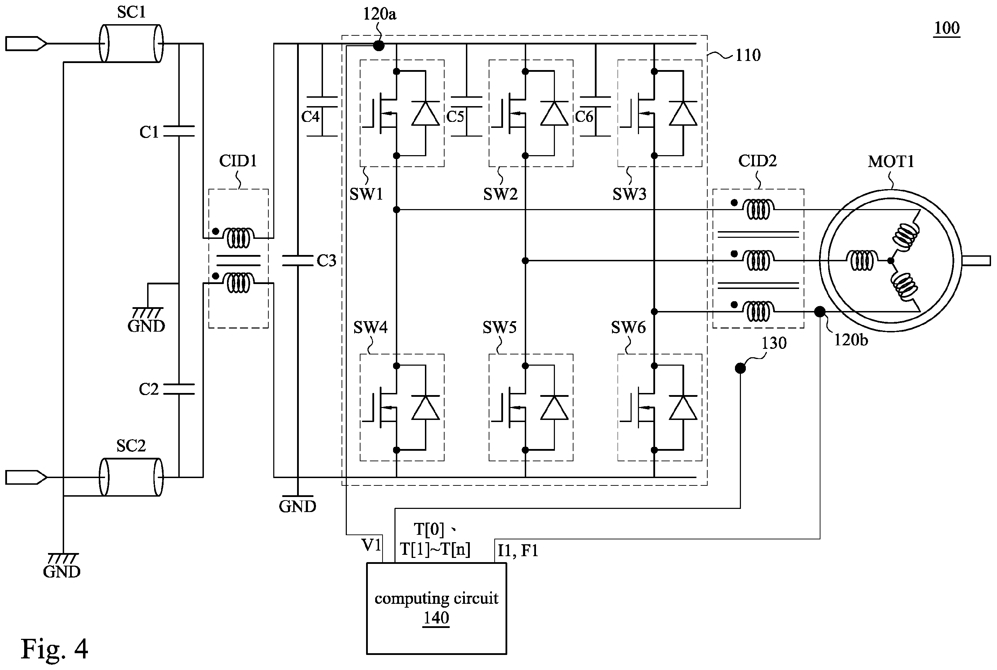

Referring to Fig. 4, Fig. 4 is a schematic diagram of a power supply device 100 according to an embodiment of the present disclosure. Referring to Fig. 4, Fig. 4 is a schematic diagram of a power supply device 100 according to an embodiment of the present disclosure. The working unit WU1 in Fig. 1 corresponds to the remaining circuits of the power supply device 100 in Fig. 4, excluding a motor MOT1. In Fig. 4, the power supply device 100 comprises cables SC1 and SC2, chokes CID1 and CID2, capacitors C1-C6, the motor MOT1, an inverter 110, a voltage measuring device 120a, a current measuring device 120b, a temperature sensor 130, and a computing circuit 140.

In one embodiment, the power supply device 100 can be configured in a power supply system of an electric vehicle (as shown in the embodiment of Fig. 4, to power a motor MOT1). However, the present disclosure is not limited thereto, and the power supply device 100 can also be configueed in a renewable energy system (e.g., solar energy or wind energy) or a power supply device based on direct current (e.g., a battery) feeding power to an alternating current grid. In these examples, the load may be replaced by an alternating current grid (not shown) or other similar alternating current power loads instead of the motor MOT1 shown in Fig. 4. The inverter 110 is configured to convert direct current power input (e.g., a battery, a solar panel, a wind turbine) into specific alternating current power output.

In one embodiment, the inverter 110 of the power supply device 100 comprises switches SW1-SW6. The main function of the inverter 110 is to convert direct current input into alternating current output of a specific specification.

In one embodiment, the switches SW1-SW6 may be switching elements such as insulated gate bipolar transistors (IGBT) or metal oxide semiconductor field effect transistors (MOSFET). The computing circuit 140 is configured to generate gate signals to drive the switches SW1-SW6, thereby controlling the operations of the switches SW1-SW6. The switches SW1-SW6 switch their switching states according to the gate signals to generate a three-phase AC power. The switches SW1-SW6 are controlled by precise switching operations to generate waveforms of required frequency and voltage. Three groups of switches SW1-SW6 form a three-phase system, and each group controls the voltage of one phase, thereby forming a balanced three-phase AC power. The output frequency can be adjusted by adjusting the switching speed of switches SW1-SW6 to control the rotational speed of motor MOT1(e.g., the AC frequency F1 in Fig. 4). Precise switch controlling operation can maximize the control of circuit power consumption, reduce overall energy loss of the power supply device 100, and improve system efficiency.

In one embodiment, the cables SC1 and SC2 can receive an input voltage and be coupled to the ground terminal GND. The cable SC1 can also be coupled to a first terminal of the capacitor C1. The first terminal of the capacitor C1 is coupled to the ground terminal GND and a first terminal of the capacitor C2. The cable SC2 can also be coupled to a second terminal of the capacitor C2. In one embodiment, the cables SC1 and SC2 can be shielded cables having surfaces coated with insulating materials.

The first input terminal of choke CID1 is coupled to the first terminal of capacitor C1. The first output terminal of the choke CID1 is coupled to the first terminal of the capacitor C3 and the first terminal of the capacitor C4. The second input terminal of the choke CID1 is coupled to the second terminal of the capacitor C2. The second output terminal of the choke CID1 is coupled to the second terminal of the capacitor C3 and the ground terminal GND. The second terminal of the capacitor C4 is coupled to the ground terminal GND.

As shown in Fig. 4, the capacitor C5 and the capacitor C6 may also be disposed in the inverter 110. A first terminal of the switch SW1 is coupled to the capacitor C4, the capacitor C5, a first terminal of the switch SW2, the capacitor C6, and a first terminal of the switch SW3. A second terminal of the switch SW1 is coupled to a first terminal of the switch SW4. A second terminal of the switch SW2 is coupled to a first terminal of the switch SW5. A second terminal of the switch SW3 is coupled to a first terminal of the switch SW6. A second terminal of the switch SW4, a second terminal of the switch SW5, and a second terminal of the switch SW6 are all coupled to the ground terminal GND.

The inverter 110 is coupled to the input terminal of the choke CID2. The three-phase input terminal of the motor MOT1 is coupled to the output terminal of the choke CID2.

The measuring terminal of the voltage measurer 120a can be disposed at the terminal of any of the switches SW1-SW6 within the inverter 110 to measure the voltage on the switch. In the embodiment of Fig. 4, the measuring terminal of the voltage measurer 120a is disposed at the first terminal of the switch SW1 to measure the voltage V1 on the switch SW1, but the present disclosure is not limited thereto.

The measuring terminal of the current meter 120b can be disposed at one of the output terminals of the choke CID2, which is also one of the three-phase input terminals of the motor MOT1, to measure the current I1 flowing through the choke CID2. The current meter 120b can have a frequency measurement function. Since the input terminal of the motor MOT1 receives an AC power, the current meter 120b can measure the AC frequency F1 while measuring the current I1.

The measuring terminal of the temperature sensor 130 can be disposed at any location near the choke CID1 or CID2 to measure the initial temperature T[0] of the choke at the moment of operation (also called the "initial phase") and the operating ambient temperature T[1]-T[n] after the choke has operated for a period of time. Here, the "n" can be any positive integer greater than 1, representing the amount of times the temperature sensor 130 measures the choke CID2 during its operation, and it can also represent the amount of operating ambient temperatures measured by temperature sensor 130 from the location near the choke CID2. In some embodiments, the measuring terminal of the temperature sensor 130 may also be disposed at the location near the choke CID2, and the present disclosure is not limited thereto.

The computing circuit 140 is coupled to the voltage measuring device 120a, the current measuring device 120b, and the temperature sensor 130. The computing circuit 140 receives the voltage V1 through the voltage measuring device 120a, and receives the current I1 and the AC frequency F1 through the current measuring device 120b. The computing circuit 140 can receive the initial temperature T[0] and the operating ambient temperatures T[1]-T[n] through the temperature sensor 130.

In one embodiment, the computing circuit 140 controls and performs over-temperature protection on the choke by monitoring/estimating the transient temperature of the choke CID2. The method of over-temperature protection is to adjust the voltage V1, current I1 and AC frequency F1 by switching switches SW1-SW6. The following embodiments will also explain in detail how the computing circuit 140 of the present disclosure monitors/estimates the transient temperature and the specific method of the subsequent over-temperature protection.

### Embodiment of wafer temperature estimation-timely protection

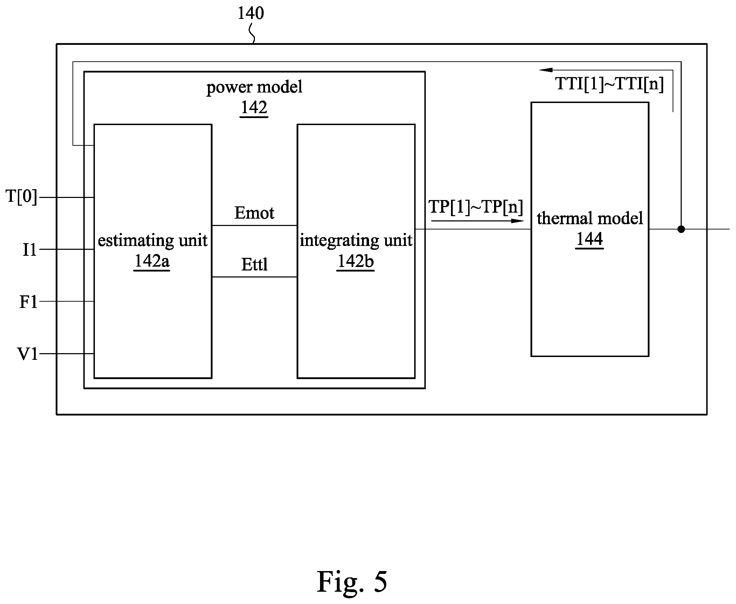

In one embodiment, the computing circuit 140 of Fig. 5 may execute the power model and the thermal model to calculate to obtain the transient ideal temperature TTI[1]-TTI[n].

In the initial phase, the computing circuit 140 may receive the initial temperature T[0] through the temperature sensor 130. The computing circuit 140 may execute the power model and calculate to obtain the transient power TP[1] based on the initial temperature T[0], the voltage V1 measured by the voltage measuring device 120a in the initial phase, and the current I1 and the AC frequency F1 measured by the current measuring device 120b in the initial phase. After calculating the transient power TP[1], the computing circuit 140 may then execute the thermal model and calculate to obtain the transient ideal temperature TTI[1] of the choke CID2 based on the transient power TP[1].

After the initial phase, the power supply device 100 can continue to operate, and the temperature in the inverter 110 may increase over time, the thermal resistance of the choke CID2 may change with the temperature increasing, thereby changing the voltage V1 on the switch SW1 and the current I1 flowing through the choke CID2. When the power supply device 100 is operating, the computing circuit 140 can first receive the initial temperature T[0] through the temperature sensor 130, and then execute the power model 142 to calculate to obtain the transient power TP[2] of the choke CID2 according to the transient ideal temperature TTI[1], the voltage V1 measured in real time by the voltage measuring device 120a, and the current I1 measured in real time by the current measuring device 120b. After obtaining the transient power TP[2], the computing circuit 140 may then execute the thermal model 144 and calculate to obtain the transient ideal temperature TTI[2] of the choke CID2 based on the transient power TP[2].

Next, the computing circuit 140 may continue to execute the power model and the thermal model, and calculate to obtain the transient ideal temperature TTI[3] based onthe current I1, the AC frequency F1, and the transient ideal temperature TTI[2]. The computing circuit 140 may continuously iterate according to the above operations, and calculate to obtain the temperature value of the choke CID2 at a certain time point based on the current I1 and the AC frequency F1 of the choke CID2 at a certain time point and the voltage V1 of the switch SW1 at the time point.

In summary, according to the power model and the thermal model, the power supply device 100 can instantly calculate to obtain the transient temperature of the choke CID2 by only measuring the voltage V1 on the inverter switch SW1 and the current I1 and the AC frequency F1 of the choke CID2.

In addition to the aforementioned functions, in the embodiment of Fig. 4, the computing circuit 140 of the power supply device 100 can further compare the transient ideal temperature of the choke CID2 with the operating ambient temperature measured by the temperature sensor at a certain time point after the power supply device 100 operates from the initial phase to the time point, and then determine whether the choke CID2 is abnormal.

When the computing circuit 140 determines that the choke CID2 is abnormal (e.g., the transient temperature is too high or the service life is insufficient), the computing circuit 140 quickly shuts off the power supply to the motor MOT1 by deactivating the switches SW1-SW6, preventing the current from flowing through the choke CID2 and protecting the system from damage caused by overload or faults. The coordinated operation of the switches SW1-SW6 can ensure stable and efficient operation of the power supply device 100.

The computing circuit 140 can calculate to obtain the transient ideal temperature of the choke CID2 at the time point mentioned above through the power model and the thermal model. The computing circuit 140 can receive the operating ambient temperature measured by the temperature sensor 130 at the time point. In addition, the computing circuit 140 can set a conduction function, and the conduction function is determined according to the arranged location of the measuring terminal of the temperature sensor 130 within the choke CID2 and thermal conductivity of the conductive medium (such as, copper wire, heat pipe or thermal conductive metal sheet) of the measuring terminal of the temperature sensor 130. The computing circuit 140 can convert the operating ambient temperature into the switch operating temperature of the choke CID2 according to the conduction function. In other words, the computing circuit 140 can estimate the choke operating temperature of the choke CID2 according to the conduction function and the operating ambient temperature. The computing circuit 140 can compare the choke operating temperature and the transient ideal temperature of the choke CID2, and then determine whether the choke CID2 is abnormal at the time point.

When the difference value between the choke operating temperature and the transient ideal temperature is greater than a first threshold, it means that the choke CID2 has degraded, resulting in a larger thermal resistance. In this case, the computing circuit 140 can send a control signal to reduce the current I1 flowing through the choke CID2, thereby allowing that the power supply device 100 to enter a load reduction mode to extend the service life of the power supply device 100.

When the difference value between the choke operating temperature and the transient ideal temperature is greater than the second threshold, it means that the choke CID2 has been over-degraded. If left unaddressed, it could cause the entire power supply device 100 to malfunction. In this embodiment, the second threshold is higher than the first threshold. In this case, the computing circuit 140 may send the control signal to stop the switches SW1 - SW6 in the inverter 110 from supplying current to the motor MOT1. In some embodiments, when the computing circuit 140 detects this phenomenon, it can generate and send an warning message (such as a description text, a pattern, an alarm sound) to a display, a speaker, or other output interface. This notifies users or maintenance personnel of the degraded phenomenon of the choke CID2, allowing them to perform targeted repairs or maintenance.

In the embodiment mentioned above, when the difference value between the choke operating temperature and the transient ideal temperature becomes greater, it may also mean that the choke CID2 may be degraded or have insufficient service life. For example, the "rainflow counting algorithm" may be executed to estimate the service life of the choke CID2 according to a deviation of the operating temperature of the choke CID2. When it is determined that the service life of the choke CID2 is insufficient, the maintenance personnel may be prompted to replace it.

In the above embodiment, for simplicity, the choke CID2 is configured as an example. In one embodiment, the computing circuit 140 can measure the current flowing through the choke CID1 to perform transient temperature estimation and over-temperature monitoring for the choke CID1. In another embodiment, the computing circuit 140 can simultaneously monitor the choke CID1 and the choke CID2 and select the highest transient temperature obtained by the computing circuit 140 from these chokes to determine whether the power supply device 100 is overheated.

Referring to Fig. 5, Fig. 5 is a schematic diagram of a computing circuit 140 according to the embodiment of Fig. 4. Specifically, Fig5 records the power model 142 and the thermal model 144 of the computing circuit 140.

In the embodiment of Fig. 5, the power model 142 comprises an estimating unit 142a and an integrating unit 142b.

In the initial phase, the estimating unit 142a can estimate an motor power loss Emot of the motor MOT1 and a total power Ettl of the power supply device 100 according to the initial temperature T[0], the voltage V1 of the switch SW1, and the current I1 flowing through the choke CID2.

The motor power loss Emot refers to the power consumed by the motor MOT1 under an ideal condition. The total power Ettl refers to the power consumed by the power supply device 100 under the ideal condition entirely.

In this embodiment, the integrating unit 142b may receive the motor power loss Emot and the total power Ettl from the estimating unit 142a and transmits the motor power loss Emot and the total power Ettl received in the initial state as the transient power TP[1] to the thermal model.

After receiving the transient power TP[1] from the integration unit 142b, the thermal model 144 may correspondingly calculate the transient ideal temperature TTI[1] based on the transient power TP[1].

After the initial phase, the thermal model 144 can transmit the transient ideal temperature TTI[1] to the power model 142. The power model 142 can correspondingly output the transient power TP[2] to the thermal model 144, so that the thermal model 144 can calculate to obtain the transient ideal temperature TTI[2]. Similarly, the computing circuit 140 can continue to calculate to obtain the transient ideal temperature TTI[3]-TTI[n].

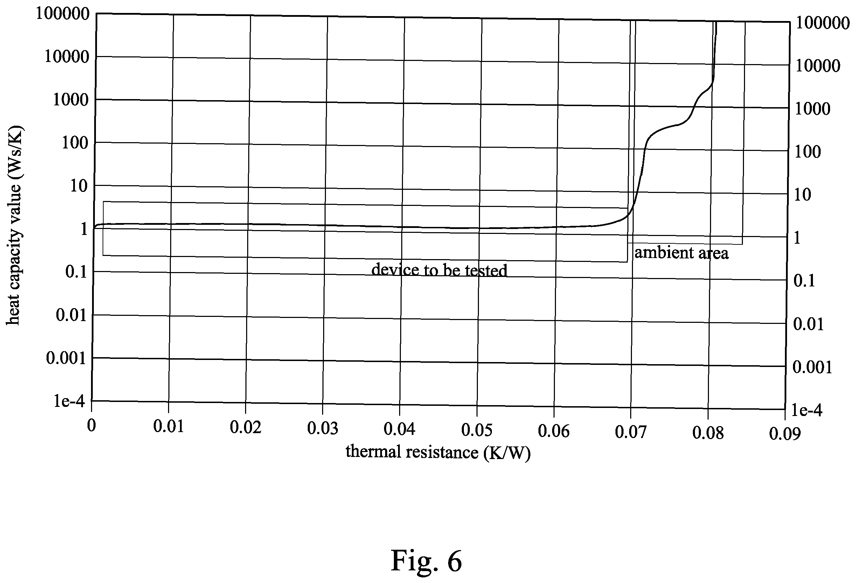

Referring to Fig. 6, Fig. 6 is a curve diagram related to the thermal model 144 in the embodiment of Fig. 5. The curve diagram of Fig. 6 can be configured to represent the corresponding relationship between the equivalent thermal resistance value of the choke CID2 and the equivalent thermal capacitance value of the choke CID2. The values and units of the coordinate axes in Fig. 6 are for reference only and are not actual values.

The curve in Fig. 6 can be a preset curve, and the preset curve is obtained by measuring the thermal resistance and thermal capacitance values of the device to be tested and the circuit operating environment used by the power supply device 100.

It should be noted that, in one embodiment, an environment equivalent to the operating environment of the power supply device 100 is constructed in a laboratory environment. Under the controlled ambient temperature, the voltage on the switch SW1 and the current flowing through the choke CID2 are measured one by one. The power loss of the choke CID2 is then inferred from the conduction current and the voltage across the switch SW1. In some embodiments, the relationship between the power loss and the ambient temperature is recorded as a comparison table or a database model to obtain a power model 142.

### Embodiment of the working unit WU1 as a battery

The curve diagram in Fig. 6 can also be configured to illustrate the case where the working unit WU1 is a battery. In this embodiment, the corresponding relationship between the equivalent thermal resistance value of the working unit WU1 and the thermal capacitance value of the working unit WU1 is shown.

In the embodiment mentioned above, the working unit WU1 of the electrical system ES1 can be a battery. In this embodiment, when input energy P_in is provided to charge the working unit WU1, the working unit WU1 can discharge to generate the output energy P_out. In the embodiment which the working unit WU1 is a battery, the computing circuit 140 can estimate the transient temperature change at the core position CRP1 based on the temperature at the surrounding circuit OC1. Furthermore, the computing circuit 140 can adjust the charging or discharging operation of the working unit WU1 based on electrical system parameters to prevent the service life of the working unit WU1 from being shortened due to excessively high temperatures at the core position CRP1 during operation.

In the embodiment which the working unit WU1 is a battery, the computing circuit 140 can utilize the temperature at the surrounding circuit OC1 to control the operating conditions and electrical system parameters of the working unit WU1 to evaluate the transient thermal resistance displacement of the working unit WU1, thereby estimating the degrading degree of battery (working unit WU1) and determining whether the battery requires maintenance, repair or replacement.

### Embodiment of the working unit WU1 as a capacitor

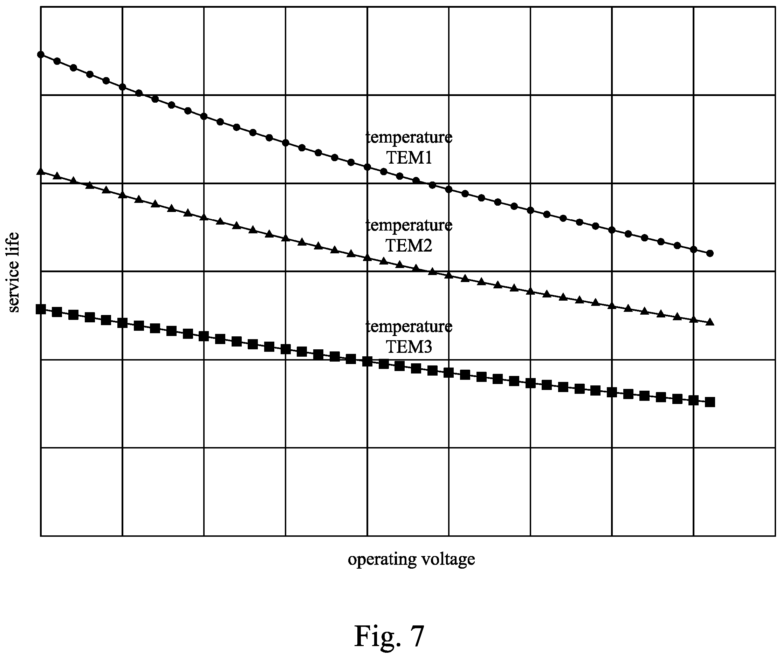

Referring to Fig. 7, Fig. 7 is a curve diagram showing the relationship between the operating voltage-operating temperature of the operating unit and the service life of the working unit according to an embodiment of the present disclosure.

In the electrical system ES1, the working unit WU1 can further be as a capacitor. When the input energy P_in is provided to charge the working unit WU1, the working unit WU1 can discharge to generate the output energy P_out. As in the embodiment mentioned above, the computing circuit 140 can obtain thermal system parameters and electrical system parameters of the working unit WU1. In the embodiment which the working unit WU1 is as a capacitor for charging or discharging, the computing circuit 140 can estimate the transient temperature change at the core position CRP1 based on the temperature at the surrounding circuit OC1. Furthermore, the computing circuit 140 can adjust the charging or discharging operation of the working unit WU1 based on the electrical system parameters to prevent the working unit WU1 from shortening its service life due to excessively high temperatures at the core position CRP1 during operation.

In the embodiment which the working unit WU1 is a capacitor, the computing circuit 140 can evaluate the transient thermal resistance displacement of the working unit WU1 through the temperature of the surrounding circuit OC1 (i.g., the temperatures TEM1, TEM2, and TEM3 in Fig. 7), the operatng condition of the working unit WU1, and the electrical system parameters, and then estimate the degrading degree of the capacitor (working unit WU1) to determine whether the capacitor has reached the conditions for maintenance, repair or replacement.

### Embodiment of predicting maintenance time

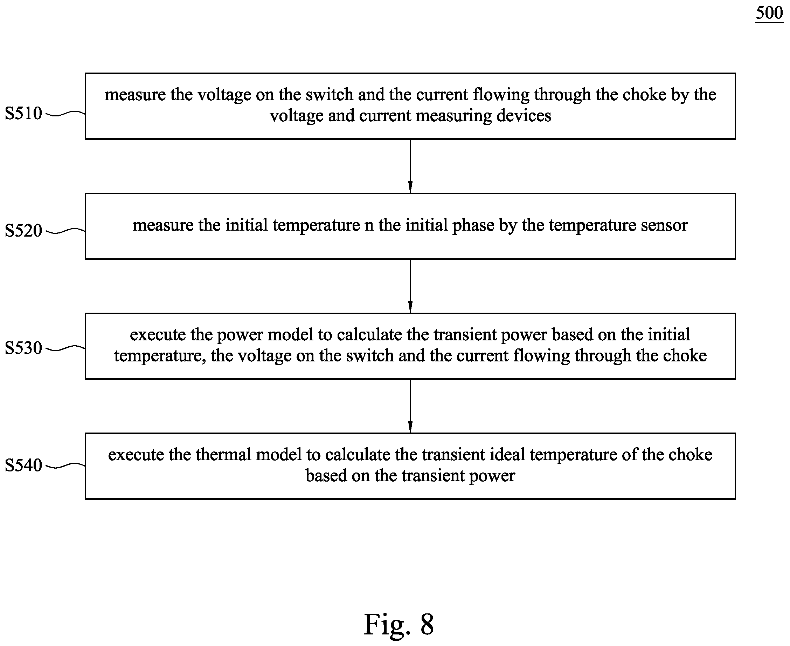

Referring to Fig. 8, Fig. 8 is a flow chart of a temperature measurement method 500 according to an embodiment of the present disclosure. The temperature measurement method 500 is configured to illustrate the operation method of the power supply device 100.

In step S510, the power supply device 100 may measure the voltage V1 on the switch SW1 and the current I1 flowing through the choke CID2 by the voltage and current measuring devices (i.e., the voltage measuring device 120a and the current measuring device 120b).

In step S520, the power supply device 100 may measure the initial temperature T[0] in the initial phase by the temperature sensor 130.

In step S530, the power supply device 100 may execute the power model 142 to calculate the transient power TP[1] based on the initial temperature T[0], the voltage V1 on the switch SW1 and the current I1 flowing through the choke CID2.

In step S540, the power supply device 100 may execute the thermal model 144 to calculate the transient ideal temperature TTI[1] of the choke CID2 based on the transient power TP[1]. In this step, the power supply device 100 may also record the thermal system parameter and the electrical system parameter generated by the thermal model 144.

After step S540, the power supply device 100 may receive the transient ideal temperature TTI[1] and continuously calculate to obtain the transient ideal temperature TTI[2]-TTI[n] according to the temperature measurement method 500. In this step, the power supply device 100 may also record multiple sets of thermal system parameters and electrical system parameters, and further record the value changes of the thermal system parameters and the electrical system parameters.

In this embodiment, the power supply device 100 can analyze the numerical changes in thermal and electrical system parameters through numerical fitting, statistical methods, artificial intelligence deep learning, and other methods. Based on these records, it can predict the time point at which inverter 110 will reach degraded. This time point can be replaced with various representations such as "electric vehicle mileage" or "amount of trips," or simply a date and time, and the present disclosure is not limited thereto.

In summary, based on power model 142 and thermal model 144, the power supply device 100 of the present disclosure can instantly calculate to obtain the transient temperature of the choke by measuring the voltage on the switch and the current flowing through the choke. In addition, in some circumstances, the power supply device 100 of the present disclosure can also determine whether the choke has degraded by comparing the transient ideal temperature with the ambient temperature when the system is operating.

The above are only preferred embodiments of the present disclosure. Various modifications and variations can be made to the structure of the present disclosure without departing from the scope or spirit of the invention. In view of the foregoing, it is intended that the present invention cover modifications and variations of this invention provided they fall within the scope of the following claims.

## Claims

1. A power supply device, comprising:
a choke;
a voltage current measuring device, configured to measure a current flowing through the choke and a voltage on an inverter;
a temperature sensor, configured to measure an initial temperature in an initial phase; and
a computing circuit, coupled to the voltage current measuring device and the temperature sensor, and the computing circuit is configured to:
execute a power model to calculate to obtain a first transient power of the choke based on the initial temperature, the voltage and the current; and
execute a thermal model to calculate to obtain a first transient ideal temperature of the choke based on the first transient power of the choke.

2. The power supply device of claim 1, wherein the computing circuit is further configured to:
execute the power model to calculate to obtain a second transient power of the choke according to the first transient ideal temperature, the voltage, and the current when the power supply device is operating; and
execute the thermal model to calculate to obtain a second transient ideal temperature of the choke according to the second transient power.

3. The power supply device of claim 1, wherein the computing circuit is further configured to:
measure an operating ambient temperature by the temperature sensor when the power supply device is operating;
estimate a choke operating temperature of the choke based on the operating ambient temperature and a transfer function between the choke and the temperature sensor; and
compare the choke operating temperature with the first transient ideal temperature to determine whether the choke is abnormal.

4. The power supply device of claim 3, wherein,
in response to a difference value between the choke operating temperature and the first transient ideal temperature being higher than a first threshold, the computing circuit sends a control signal to reduce the current flowing through the choke; and
in response to the difference value between the choke operating temperature and the first transient ideal temperature being higher than a second threshold, the computing circuit sends the control signal to stop the choke from operating, and the second threshold is higher than the first threshold.

5. The power supply device of claim 1, wherein the power model estimates an on-state switching power loss, a turn-off switching power loss, a reverse recovery loss power, and a switch conducting voltage of the choke according to the initial temperature, and the voltage and the current of the choke, and calculates to obtain the first transient power according to the on-state switching power loss, the turn-off switching power loss, the reverse recovery loss power, and the switch conducting voltage.

6. A temperature measurement method for a power supply device, the power supply device comprises a choke, a voltage current measuring device, a temperature sensor and a computing circuit, wherein the temperature measurement method comprises:
by the voltage current measuring device, measuring a current flowing through the choke and a voltage on a inverter;
by the temperature sensor, measuring an initial temperature in an initial phase;
by the computing circuit, executing a power model to calculate a first transient power of the choke based on the initial temperature, and the voltage and the current; and
by the computing circuit, executing a thermal model to calculate a first transient ideal temperature of the choke based on the first transient power.

7. The temperature measurement method of claim 6, further comprising:
obtaining a second transient power of the choke based on the first transient ideal temperature, the voltage and the current when the power supply device is operating;
executing the thermal model to calculate to obtain a second transient ideal temperature of the choke according to the second transient power.

8. The temperature measurement method of claim 6, further comprising:
measuring an operating ambient temperature by the temperature sensor when the power supply device is operating;
estimating a choke operating temperature of the choke based on the operating ambient temperature and a transfer function between the choke and the temperature sensor; and
comparing the choke operating temperature with the first transient ideal temperature to determine whether the choke is abnormal.

9. The temperature measurement method of claim 8, further comprising:
in response to a difference value between the choke operating temperature and the first transient ideal temperature being higher than a first threshold, sending a control signal to reduce the current flowing through the choke; and
in response to the difference value between the choke operating temperature and the first transient ideal temperature being higher than a second threshold, sending the control signal to stop the choke from operating, and the second threshold is higher than the first threshold.

10. The temperature measurement method of claim 6, wherein the power model estimates an on-state switching power loss, a turn-off switching power loss, a reverse recovery loss power, and a switch conducting voltage of the choke according to the initial temperature, and the voltage and the current of the choke, and calculates to obtain the first transient power according to the on-state switching power loss, the turn-off switching power loss, the reverse recovery loss power, and the switch conducting voltage.

11. An electrical system, comprising:
a working unit, comprising a core position, the working unit is configured to generate an output energy according to an input energy; and
a surrounding circuit, corresponding to the working unit;
wherein the working unit comprises a magnetic element, the magnetic element is located at the core position of the working unit,
wherein a temperature change and a time relationship between the core position of the electrical system and the surrounding circuit correspond to a thermal impedance function,
wherein the electrical system estimates a thermal system parameter of the core position by a temperature data of the surrounding circuit and the thermal impedance function.

12. The electrical system of claim 11, wherein the working unit comprises a switch, the switch is arranged at the core position of the working unit.

13. The electrical system of claim 12, wherein the thermal system parameter of the core position corresponds to a transient thermal resistance.

14. The electrical system of claim 12, wherein the thermal system parameter of the core position corresponds to a temperature.

15. The electrical system of claim 12, wherein the electrical system performs overheat protection of the working unit and/or serves as a control parameter based on the thermal system parameter of the core position.

16. The electrical system of claim 15, wherein the thermal system parameter of the core position corresponds to a transient thermal resistance and temperature.

17. The electrical system of claim 12, wherein the input energy of the electrical system comprises an electrical energy input, and the working unit outputs the output energy under control of an operating condition of the working unit;
wherein the electrical system establishes an electrical system parameter by establishing a relationship between a key electrical characteristic of the working unit and the operating condition.

18. The electrical system of claim 17, wherein the working unit evaluates a degradation of a physical state of the core position by reference to the thermal system parameter and the electrical system parameter.

19. The electrical system of claim 18, wherein the working unit compares the thermal system parameter by using the thermal impedance function and the temperature data at the surrounding circuit, references the operating condition of the working unit, and compares the thermal system parameter obtained by computer-aided engineering with the electrical system parameter to evaluate a transient thermal resistance shift, thereby estimating an degrading degree of the working unit.

20. The electrical system of claim 17, wherein the working unit is one of a battery, a capacitor, and a magnetic element.

21. The electrical system of claim 20, wherein the working unit is the capacitor, and the electrical system controls the operating condition of the working unit based on a relationship between an operating voltage and an operating temperature and a service life of the capacitor.
